# EUROPÄISCHE PATENTANMELDUNG

(11) **EP 0 940 722 A2**
(43) Veröffentlichungstag der Anmeldung: **08.09.1999**
(21) Anmeldenummer: 99102271.6
(22) Anmeldetag: 05.02.1999
(51) Int. Cl.: G03F 7/20

(54) **Beleuchtungssystem und REMA- (Retikel-Maskierungs-) Objektiv mit Linsenverschiebung und Betriebsverfahren dafür**

(30) Priorität: 05.03.1998 DE 19809395
(71) Anmelder: Carl Zeiss, 89518 Heidenheim (Brenz) (DE); CARL-ZEISS-STIFTUNG, trading as CARL ZEISS, 89518 Heidenheim (DE)
(72) Erfinder: Schultz, Jörg, 73431 Aalen (DE); Wangler, Johannes, 89551 Königsbronn (DE)

(57) **Zusammenfassung**

Beleuchtungssystem für eine Mikrolithographie-Projektionsbelichtungsanlage bei dem eine sekundäre Lichtquelle (1) auf ein Retikel (33) abgebildet wird, wobei die Verzeichnung der Abbildung durch mindestens einen veränderlichen optischen Weg zwischen optischen Elementen (15, 16; 17, 18) einstellbar ist und wobei infolge der geänderten Verzeichnung die Uniformität der Beleuchtung verändert ist, insbesondere, daß sie zum Rand hin angehoben ist.

## Beschreibung

Die Erfindung betrifft ein Beleuchtungssystem nach dem Oberbegriff des Anspruchs 1, bzw. ein REMA-Objektiv nach dem Oberbegriff des Anspruchs 3 und ein Verfahren zum Betrieb eines REMA-Objektivs nach Anspruch 11.

Aus US 4,851,882 ist ein Beleuchtungssystem für eine Mikrolithographie-Projektionsbelichtungsanlage bekannt mit einem einfachen REMA-Objektiv, welches eine Feldblende, nämlich die Retikel-Maske (REMA), auf das Retikel mit der strukturierten Lithographie-Maske abbildet. Ein vorgelagertes Zoomsystem ist vorgesehen, um bei Retikels mit unterschiedlichen MaskenAbmessungen und dementsprechend unterschiedlichen Öffnungsmaßen der REMA-Blende optimale Ausleuchtung der gesamten REMA-Blenden-Fläche mit wenig Lichtverlust zu sichern. Ein konkretisiertes Ausführungsbeispiel gibt es nicht.

Hochentwickelte REMA-Objektive sind in der DE-A 195 48 805 und in der deutschen Patentanmeldung DE 196 53 983.8 der Anmelderin beschrieben. Sie sind geeignet für das Zusammenwirken mit Zoom-Axicon-Beleuchtungsoptiken nach EP-A 0 687 956 der Anmelderin und für eine Anordnung der REMA-Blende am Austritt eines Glasstabs nach US 5,646,715. Die zitierten Anmeldungen der Anmelderin werden ausdrücklich als Bestandteil der Offenbarung dieser Anmeldung angegeben. Alle haben mit dieser Anmeldung den Miterfinder Wangler gemeinsam.

EP 0 500 393 B1 beschreibt ein mikrolithographisches Projektionsbelichtungssystem mit veränderlicher Quadrupol-Beleuchtung, bei dem zwischen Wabenkondensor und Retikel-Maske eine Optik mit Verstellmöglichkeit zur Anpassung der Beleuchtungs-Uniformität vorgesehen ist. Da dem Fachmann in diesem Patent nur Blockschaltbild-artige funktionelle optische Gruppen, nicht aber ein konkretes Ausführungsbeispiel angegeben werden, hat diese Offenbarung mehr einen aufgabenhaften Charakter.

US-A-5,311,362 beschreibt ein mikrolithographisches Projektionsbelichtungssystem mit veränderlicher numerischer Apertur des Beleuchtungssystems, bei dem auch die numerische Apertur des Projektionsobjektivs veränderlich ist und abhängig von beiden numerischen Aperturen eine optische Weglänge zwischen Linsen des Projektionsobjektivs verändert werden kann, wodurch Aberrationen, primär die vertikale sphärische Aberration, korrigiert werden.

Generell sind verschiedene Ausführungen von Projektionsobjektiven mit Stellmitteln zur Korrektur von veränderlichen Abbildungsfehlern bekannt.

Aufgabe der Erfindung ist es, ein Beleuchtungssystem beziehungsweise ein REMA-Objektiv dahingehend zu verbessern, daß optimale Uniformität, d.h. Gleichmäßigkeit der Beleuchtungsintensität über die gesamte Fläche des Wafers erreicht wird. Dies soll bei den verschiedensten Störungseinflüssen gelten, wie sie auch bei veränderlicher Apertur der Beleuchtung hinsichtlich numerischer Apertur und Aperturform wie Kreis, Ring, Quadrupol auftreten können.

Gelöst wird diese Aufgabe durch ein Beleuchtungssystem nach Anspruch 1 bzw. durch ein REMA-Objektiv nach Anspruch 3 und ein Betriebsverfahren dafür nach Anspruch 11.

Vorteilhafte Ausführungsformen sind Gegenstand der Unteransprüche 2, 3, 4 bis 9 und 12 bis 14.

Erstmals wird also die Verzeichnung der Beleuchtung einstellbar ausgeführt und daraus eine Steuerung und eine Regelmöglichkeit der Uniformität der Beleuchtung abgeleitet.

Ebenfalls erstmals wird in einem REMA-Objektiv eine Verstellmöglichkeit vorgesehen.

Näher erläutert wird die Erfindung anhand eines Ausführungsbeispiels und der Zeichnung.

Diese zeigt in
- Figur 1: schematisch eine Projektionsbelichtungsanlage mit verschiebbarer Linsengruppe im REMA-Objektiv;
- Figur 2: den Linsenschnitt eines REMA-Objektivs mit verschiebbarer Linsengruppe.

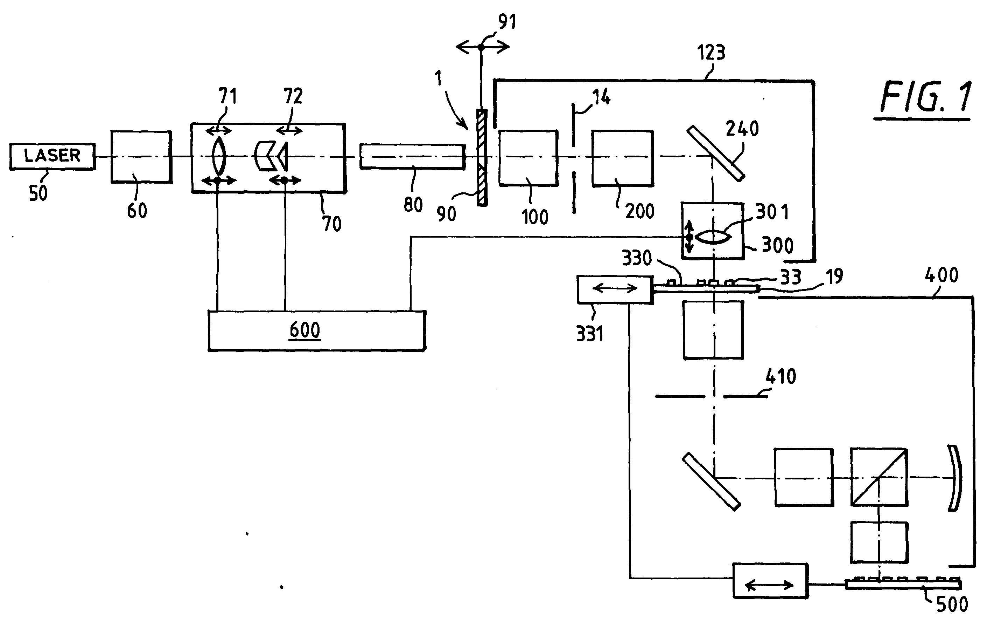

Das Beispiel der Figur 1 zeigt einen schematischen Überblick über den optischen Teil einer gesamten Projektionsbelichtungsanlage (Wafer-Scanner), in die das erfindungsgemäße REMA-Objektiv 123 mit drei Linsengruppen 100, 200, 300 enthaltend die verschiebbare Linsengruppe 301 integriert ist.

Ein Excimer-Laser 50 mit 248 nm Wellenlänge dient im Beispiel als Lichtquelle. Eine Einrichtung 60 dient zur Strahlformung und Kohärenzreduktion. Ein Zoom-Axicon-Objektiv 70 ermöglicht die bedarfsgerechte Einstellung verschiedener Beleuchtungsarten. Dazu ist ein verstellbares Zoom 71 und ein verstellbares Axicon-Paar 72 vorgesehen. Es ist wie die Gesamtanordnung aus der DE 196 53 983 der Anmelderin bekannt.

Das Licht wird in den Glasstab 80 eingekoppelt, der zur Mischung und Homogenisierung dient.

Unmittelbar daran schließt das Retikel-Maskierungssystem 90 an, das in der Objektebene 1 des REMA-Objektivs 123 liegt. Dieses besteht aus der ersten Linsengruppe 100, der Pupillenebene (Blendenebene) 14, der zweiten Linsengruppe 200, dem Umlenkspiegel 240, der dritten Linsengruppe 300 und der Bildebene 19. Geeignete REMA-Objektive sind aus DE-A 195 48 805 und DE 196 53 983 bekannt.

In der Bildebene 19 des REMA-Objektivs 123 ist das Retikel 330 angeordnet, das von der Wechsel- und Justiereinheit 331 präzise positioniert wird.

Es folgt das Projektionsobjektiv 400, im Beispiel das katadioptrische Objektiv nach WO 95/32446 mit der Pupillenebene 410. In der Bildebene des Projektionsobjektivs 400 ist der Wafer 500 mit zugehöriger Justier- und Bewegungseinheit 501 angeordnet.

Im folgenden wird davon ausgegangen, daß die Anordnung als Scanner ausgebildet ist, d.h. Retikel 33 und Wafer 500 werden synchron im Geschwindigkeitsverhältnis des Abbildungsmaßstabs des Projektionsobjektivs 400 linear bewegt und das Beleuchtungssystem 50 bis 123 erzeugt einen quer zur Bewegungsrichtung orientierten schmalen Schlitz.

In der dritten Linsengruppe 300 des REMA-Objektivs 123 ist die erfindungsgemäß verstellbare Linsengruppe 301 vorgesehen, welche durch Veränderung eines Luftraums die optische Weglänge beeinflußt. Eine Steuereinheit 600 ist mit den stellbaren Gliedern 71, 72, 301 verbunden und steuert diese in gegenseitiger Abhängigkeit.

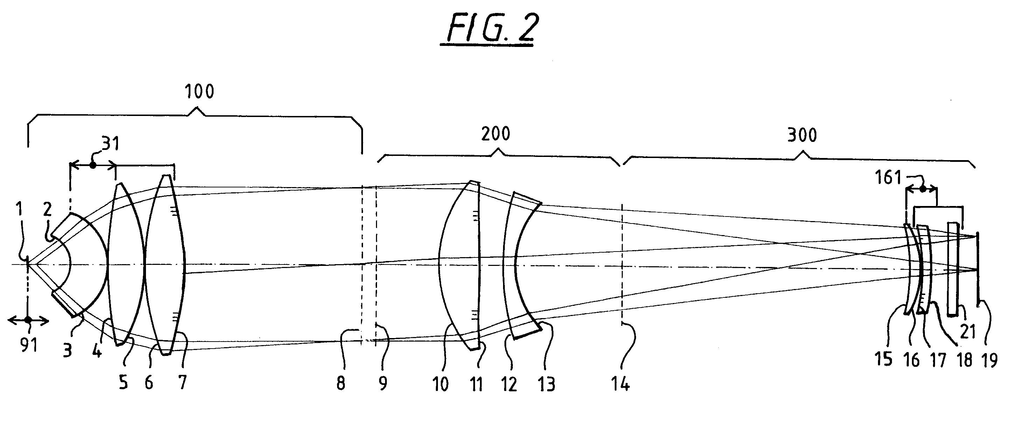

Das im Linsenschnitt der Figur 2 gezeigte REMA-Objektiv ist eine Abwandlung des Objektivs nach Figur 1 der DE 196 53 983. Dabei sind die Maße nach Tabelle 1 der Tabelle 1 der zitierten Schrift für die Flächen 1 bis 19 übernommen.

Jedoch ist der Luftraum zwischen den Flächen 16, 17 mit einem Aktuator 161 axial verstellbar, so daß er um einzelne Millimeter erhöht (oder auch verringert) werden kann. Die Linse 17, 18 und der Graufilter 21 werden kollektiv verschoben, Dadurch wird die Verzeichnung des REMA-Objektivs erhöht (verringert) und die Intensitätsverteilung in der Bildebene 19 (am Retikel 33) zum Rand hin angehoben (verringert). Der gleiche Effekt tritt am Wafer auf. Die Schnittweite des Objektivs 123 bleibt unverändert.

Im Beispiel und in vielen ähnlichen Ausführungsformen ergibt sich dadurch eine Verschlechterung der Kantensteilheit bei der Abbildung des REMA-Systems 90 auf das Retikel 33. Dies ist aber kompensierbar, indem entweder der Objektabstand geringfügig erhöht wird - durch Verschieben des REMA-Systems 90 mit einem Aktuator 91 - oder indem ein weiterer Luftraum des REMA-Objektivs 123 wenig verändert wird. Im Beispiel ist dies der Luftraum zwischen den Flächen 3 und 4, welcher mit dem Aktuator 31 axial verändert wird.

Im Beispiel ist vorgesehen, daß der Luftraum 16/17 um 2,2 mm erhöht wird, was eine Intensitätsanhebung am Rand des Bildfelds von 0,5 % bewirkt. Verbunden damit ist eine Verbreiterung der Kante um 0,1 mm und eine Telezentrieverletzung um 0,1 mrad.

Durch Verkürzung der Gegenstandsweite 1/2 um 0,02 mm reduziert sich die Verbreiterung auf nur noch 0,01 mm, bei gleicher Telezentriequalität. Alternativ oder ergänzend dazu kann auch der Luftraum 3/4 verringert werden.

Tabelle 1 gibt die Designdaten dieses REMA-Objektivs für die Grundstellung der verschiebbaren Elemente an.

Durch die Variation der Lufträume bleibt die transportierte Lichtmenge konstant. Betrachtet man als Alternativlösung den Einsatz eines Graufilters mit zur Mitte ansteigender Abdunkelung, so wird auf jeden Fall ein Teil des Lichtes durch Absorption verschenkt.

Die vorgeschlagene Lösung ist dann angebracht, wenn die Intensitätsverteilung in der Retikelebene 19 bzw. 33 in kleinen Grenzen (Delta I = ± 0,5 % bis 2,0 %) verlustfrei, kontinuierlich und von außen steuerbar variiert werden soll. Damit wird dann auch die Uniformität am Wafer entsprechend steuerbar.

Die Uniformitäts-Korrektur kann dann an die Steuerung 600 gekoppelt werden, welche z.B. auch die Zoom-Axicon-Funktion steuert.

Erhöht man den Variationsweg des Luftraums weiter, so ist die Verschlechterung der Telezentrie im Vergleich zum Uniformitäts-Gewinn nicht mehr tragbar.

Wenn sich die Abweichungen der Uniformität von kleinen Aperturen über große zu Ringaperturen ändern, ist es sinnvoll, die Verschiebung der Linsengruppe 301 als Korrekturmittel mit einem Grauwert-Verlaufsfilter (21 in Fig. 2) zu kombinieren, das einen radialen Transmissionsverlauf entsprechend dem Mittelwert aufweist. Dazu kann die Belichtungsverteilung auf dem Wafer 500 unter Berücksichtigung der gesamten Projektionsbelichtungsanlage exemplarspezifisch ausgewertet werden.

Die erfindungsgemäße Verschiebung korrigiert dann nur noch die veränderlichen Anteile entsprechend der Beleuchtungsapertur um den Mittelwert.

**Tabelle 1**

| | | | |
|---|---|---|---|
| Maßstab: 4,444 : 1 Wellenlänge: 248,33 nm | | | |

| | Radius | Dicke | Material |
|---|---|---|---|
| 1 | | 55,240 | |
| 2 | -38,258 | 46,424 | Quarz |
| 3 | -66,551 | ,633 | |
| 4 | 881,696 | 45,341 | Quarz |
| 5 | -190,791 | ,924 | |
| 6 | 374,111 | 47,958 | Quarz |
| 7 | -287,518 | 222,221 | |
| 8 | Blende | 17,900 | |
| 9 | ∞ | 79,903 | |
| 10 | 164,908 | 52,350 | Quarz |
| 11 | -1246,141 | 27,586 | |
| 12 | 280,226 | 19,580 | Quarz |
| 13 | 114,495 | 133,941 | |
| 14 | ∞ | 365,253 | |
| 15 | -216,480 | 12,551 | Quarz |
| 16 | -113,446 | 1,399 | |
| 17 | -329,056 | 10,797 | Quarz |
| 18 | -552,687 | 60,000 | |
| 19 | ∞ | ,000 | |

| Fläche | Asphärische Konstanten | | |
|---|---|---|---|
| 7 | K = -,00640071 C1 = ,347156E-07 C2 = ,802432E-13 C3 = -,769512E-17 C4 = ,157667E-21 | | |
| 11 | K = +,00104108 C1 = ,431697E-07 C2 = -,564977E-13 C3 = -,125201E-16 C4 = ,486357E-21 | | |
| 17 | K = +,00121471 C1 = -,991033E-07 C2 = -,130790E-11 C3 = -,414621E-14 C4 = ,200482E-17 C5 = -,392671E-21 | | |

## Patentansprüche

1. Beleuchtungssystem für eine Mikrolithographie-Projektionsbelichtungsanlage bei dem eine sekundäre Lichtquelle (1) auf ein Retikel (33) abgebildet wird, dadurch gekennzeichnet, daß die Verzeichnung der Abbildung durch mindestens einen veränderlichen optischen Weg zwischen optischen Elementen (15, 16; 17, 18) einstellbar ist.

2. Beleuchtungssystem nach Anspruch 1, dadurch gekennzeichnet, daß infolge der geänderten Verzeichnung die Uniformität der Beleuchtung verändert ist, insbesondere, daß sie zum Rand hin angehoben ist.

3. REMA-Objektiv enthaltend optische Elemente, insbesondere Linsen, dadurch gekennzeichnet, daß der optische Weg zwischen zwei optischen Elementen (15, 16; 17, 18) verstellbar ist, insbesondere durch Verschieben.

4. Beleuchtungssystem nach Anspruch 1 oder 2, bei dem durch Verstellen, Verändern oder Tauschen optischer Elemente (71, 72) die Apertur der Beleuchtung nach Art und/oder Größe verändert werden kann.

5. Beleuchtungssystem nach Anspruch 4, dadurch gekennzeichnet, daß die Verzeichnung durch Verstellen des optischen Wegs zwischen zwei Elementen (15, 16; 17, 18) in Abhängigkeit von der Apertur einstellbar ist.

6. Beleuchtungssystem nach mindestens einem der Ansprüche 1-2 und 4-5, dadurch gekennzeichnet, daß es ein REMA-Objektiv (123) enthält, und daß in diesem der die Verzeichnung bestimmende veränderliche optische Weg zwischen optischen Elementen (15, 16; 17,18) vorgesehen ist.

7. Beleuchtungssystem nach Anspruch 6, dadurch gekennzeichnet, daß im REMA-Objektiv (123) mindestens ein zweiter optischer Weg zwischen zwei optischen Elementen (2, 3; 4, 5) veränderlich ist.

8. Beleuchtungssystem nach Anspruch 6, dadurch gekennzeichnet, daß der Objektabstand (1-2) des REMA-Objektivs (123) veränderlich ist.

9. Beleuchtungssystem nach mindestens einem der Ansprüche 1-2 und 4-8, gekennzeichnet durch die Ausbildung als Beleuchtungssystem eines Wafer-Scanners mit schlitzförmigem Beleuchtungsquerschnitt.

10. Beleuchtungssystem nach mindestens einem der Ansprüche 1-2 und 4-9, dadurch gekennzeichnet, daß zusätzlich ein Grauwert-Verlaufsfilter (21) vorgesehen ist.

11. Verfahren zum Betrieb eines Beleuchtungssystems mit veränderlicher Apertur und mit REMA-Objektiv (123) für eine Mikrolithographie-Projektionsbelichtungsanlage, dadurch gekennzeichnet, daß mindestens ein optischer weg zwischen zwei optischen Elementen (15, 16; 17, 18) des REMA-Objektivs (123) in Abhängigkeit von der Apertur des Beleuchtungssystems verändert wird.

12. Verfahren nach Anspruch 11, dadurch gekennzeichnet, daß durch die Veränderung des optischen Wegs die Uniformität der Beleuchtung am Wafer (500) gesteigert wird.

13. Verfahren nach Anspruch 11 oder 12, dadurch gekennzeichnet, daß der optische Weg durch Verschiebung eines optischen Elements (15, 16) verändert wird.

14. Verfahren nach mindestens einem der Ansprüche 11-13, dadurch gekennzeichnet, daß mindestens ein zweiter optischer Weg im REMA-Objektiv (123) oder der Objektabstand des REMA-Objektivs (123) verstellt wird.
